# EUROPEAN PATENT SPECIFICATION

(11) **EP 0 488 165 B1**
(45) Date of publication and mention of the grant of the patent: **04.02.1998**
(21) Application number: 91120181.2
(22) Date of filing: 26.11.1991
(51) Int. Cl.: C21D 1/09, C23C 26/00, B23K 26/00, G21C 19/46, C09K 5/04, G21C 3/07, G21C 21/00, G21C 7/08

(54) **A metallic member with an improved surface layer**
Metallbauteil mit verbesserter Oberflächenschicht
Pièce métallique à couche superficielle améliorée

(30) Priority: 30.11.1990 JP 329062/90
(43) Date of publication of application: 03.06.1992
(73) Proprietor: HITACHI, LTD., Chiyoda-ku, Tokyo 101 (JP)
(72) Inventor: Yokosuka, Tsunenobu, Mito-shi (JP); Honda, Takashi, Mawatari, Katsuta-shi (JP)
(74) Representative: Beetz & Partner Patentanwälte

(56) References cited:
- EP-A- 0 204 318
- EP-A- 0 209 131
- EP-A- 0 260 706
- EP-A- 0 300 846
- WO-A-90/00630
- DE-A- 2 829 436
- US-A- 4 398 966
- US-A- 4 440 339
- US-A- 4 912 934
- METAL SCIENCE AND HEAT TREATMENT, vol. 27, nos. 3/4, March/April 1985, pages 247-251, New York, US; Y.M. LAKHTIN et al.: "Heat treatment with the use of highly concentrated energy sources. Laser hardening of 11Kh12N2V2MF steel"
- FEINWERKTECHNIK & MESSTECHNIK, vol. 96, nos. 1-2, January-February 1988, pages 37-41; Munchen, DE; A. DRENKER et al.: "Werkstoffbearbeitung mit Laserstrahlung"
- PATENT ABSTRACTS OF JAPAN, vol. 13, no. 95 (C-573), 6th March 1989; & JP-A-63 274 716 (MITSUBISHI) 11-11-1988
- WORLD PATENT INDEX LATEST, AN=90-040216 (06), Derwent Publications Ltd, London,
- GB; & JP-A-1 316 418 (NIPPON STEEL) 21-12-1989
- PATENT ABSTRACTS OF JAPAN, vol. 14, no. 30 (C-678), 19th January 1990; & JP-A-1 268 848 (HITACHI) 26-10-1989
- PATENT ABSTRACTS OF JAPAN, vol. 10, no. 120 (C-343), 6th May 1986; & JP-A-60 243 281 (KOBE SEIKOSHO) 03-12-1985
- PATENT ABSTRACTS OF JAPAN, vol. 14, no. 415 (P-1102), 7th September 1990; & JP- A-2 161 397 (TOSHIBA CORP.) 21-06-1990

## Description

### FIELD OF THE INVENTION

The present invention relates to a metallic member with an improved surface layer, a process of producing the same. Said metallic member may be used in a nuclear fuel reprocessing plant, a chemical industry plant, equipments for a nuclear power plant, an absorption refrigerator, and a semiconductor package.

### BACKGROUND OF THE INVENTION

As methods of improving the surface of a bulk material for providing a high function to the material, there are known a physical vapor deposition method (PVD), a chemical vapor deposition method (CVD), an ion-implantation method, and a laser beam processing.

Various techniques have been disclosed to make stainless steel highly corrosion resistant by improving a surface layer of the steel. JP-A-60-197879, there is disclosed a laser plating method, wherein a high density energy laser beam is externally irradiated against a surface of a stainless steel piece, such as a stainless steel plate or strip, through an aqueous solution containing a metallic ion, the surface of the stainless steel piece being in contact with the aqueous solution, and the ion metal is deposited on the surface of the stainless steel piece by making use of the resultant surface chemical reaction to thereby improve the stainless steel piece in corrosion resistance. JP-A-61-279617 discloses another method for improving corrosion resistance of an alloy steel, wherein a laser beam is irradiated against the alloy steel through an aqueous solution of an oxidizing acid or a salt thereof, the alloy steel being in contact with the aqueous solution, and thereby alloying elements contained in the alloy steel, such as chromium or molybdenum, are enriched in the surface layer of the alloy steel as to improve the corrosion resistance property of the alloy. The thickness of the deposited metal layer or the enriched layer formed on the surface of the alloy according to those methods is however limited to several to several tens nm at the largest. Thus, it is difficult to apply such methods to a functional material to which a reliability for a long term is required.

On the other hand, EP-A-0 300 846 discloses a method of superficial modification of a metallic, predominantly iron member by coating the surface with a film containing at least one salt of carboxylic acid cmoprising at least the element which serves to form an alloy layer with said metallic member and having reducing capacities when irradiated with a laser beam, by irradiating the thus coated surface with a laser beam in such a manner that a substantial thickness of the member surface melts and that said element resulting from decomposition of said salt is mixed with the molten part of the member surface, and by resolidifying the alloy thus obtained. The thickness of said alloy layer in the examples is in the range from 20 - 55 µm.

Even if heat-transfer pipes and tanks are made of a high purity stainless steel, they are liable to be damaged due to localized corrosion at a gas-liquid interface under a highly corrosive environment or at portion thereof where the temperature is locally elevated. The surface layer of the deposited metal or of the enriched alloying element of chromium, molybdenum, etc, which are formed according to the known laser processing methods, has a thickness of several nm to several tens nm at the largest, and of 20-55 µm, respectively, therefore there is a possibility that the layer may be easily damaged by contacting with a foreign article or the like.

### SUMMARY OF THE INVENTION

Thus, an object of the present invention is to provide a metallic member with an improved surface layer of a fine solidification structure, and a method of producing the same.

Said object is achieved, according to the present invention, by a method as claimed in claim 1 and a metallic member as claimed in claim 4, respectively.

Further advantageous features of said method and said metallic member are claimed in claims 2-3 and 5-9, respectively.

### BRIEF DESCRIPTION OF THE DRAWINGS

FIG. 1 is a photograph (50 magnifications) showing a metallic structure of a section of a surface-treated layer according to the present invention;
FIG. 2 is a electric potential graph of immersion tests of evaluating the intergranular corrosion resistance property;
FIG. 3 is a graph showing the results of intergranular corrosion tests in active state-passive state transition zone;
FIG. 4 is a graph showing the results of intergranular corrosion tests in passive state-over passive state transition zone;
FIG. 5 is a graph illustrating the results of intergranular corrosion tests in over passive state zone;
FIG. 6 is a diagrammatic axial section of a waste solution evaporator;
FIG. 7 is a fragmental perspective view partially cut away of a lower portion of a nuclear core;
FIG. 8 is a sectional illustration of an absorption refrigerator;
FIG. 9 is a plan view of a lead frame; and
FIGS. 10A and 10B are vertical sectional and perspective views of a semiconductor resin package, respectively.

### DETAILED DESCRIPTION OF THE INVENTION

The inventors made various studies about effects of the laser processing on the corrosion resistance property of austenitic stainless steel. As a result, it was found that the grain boundary corrosion resistance property in a nitric acid is improved mere by the laser irradiation treatment to the stainless steel. The improvement in corrosion resistance property mere by the laser irradiation is caused by a reduction of segregation of impurity elements (such as P and Si) at grain boundaries, the segregation being a primary cause of intergranular corrosion. It was also found that the grain boundary corrosion resistance property is further improved by the laser irradiation treatment to the stainless steel in an aqueous solution containing at least one metallic ion selected from the groups IVa, Va and VIa and a reducing agent. This was caused by a reduction of segregation of impurity elements (such as P and Si) at grain boundaries and by being formed a surface layer of an alloy with a strong oxide coat containing at least one element selected from the groups IVa, Va and VIa. A metallic member with a high corrosion resistance property against a strong corrosive environment can be obtained by using an aqueous solution containing particularly high-oxidizing metallic ion in the above mentioned laser irradiation treatment. Such metals include Cr⁶⁺, Fe³⁺, Ce⁴⁺, Ru⁸⁺, etc. and one or more of these metals may be used.

The inventors studied in detail influences of impurity elements on the intergranular corrosion property of austenitic stainless steel. This revealed that an improvement in the grain boundary corrosion resistance is made by reduction of a content of phospher or silicon which is an impurity element. A patent application was already filed for this invention. Industrially, it is however very hard to reduce the content of phospher or silicon below a predetermined amount, and it is hence difficult to completely overcome the segregation of phospher and silicon at grain boundaries which is a primary cause of the intergranular corrosion. Thus, under a high corrosive environment, a portion at a gas-liquid interface of a nitric acid solution including high-oxidizing ion or a portion which is locally elevated to a high temperature is likely to be damaged due to the intergranular corrosion.

These problems are solved by removing the grain boundary segregation of phosphor, silicon etc. and by forming on the surface of the metallic member an improved surface layer which is capable of mending and has a strong oxide coat excellent in the corrosion resistance property.

To achieve this object, a laser beam is irradiated to the material in an aqueous solution including at least one metallic ion, selected from the group IVa, Va and VIa and other elements claimed in claim 1, and a reducing agent, selected from the group of EDTA, hydrazine, L-ascorbic acid, indigo di-sulfonic acid, and subsequently the surface of the material may be repidly cooled from a molten state to the room temperature.

Other than austenitic stainless steel, the present invention may be applied to various kinds of metallic member made of a metal selected from the group of a carbon steel, a low alloy steel, aluminum, an aluminum alloy, copper, a copper alloy, Fi-Ni alloy with a low thermal expansion coefficient, a heat resistant steel, a nickel base alloy, a cobalt base alloy, etc.

Preferably, the surface-treated layer is 1 µm or larger and 3 mm at maximum in thickness. For a thin plate, applied to an electronic component, a thickness of 2 to 10 µm is preferable whereas for a structural member, a thickness of 0.1 to 1 mm is preferable.

The surface-treated layer may be cooled in an aqueous solution, and hence is quenched to produce a fine cellular structure of which cellular grain size is 10 µm or less. A structural austenitic stainless steel according to the invention may have a columnar cellular structure with a grain size 5 µm or below. The columnar cells have a length about 5 to 50 µm. Furthermore, in the surface-treated layer, a plurality of minutely thin solidified layers are formed along a solidified interface between the remolten zone and the non-remolten portion of the steel. This appears due to differences in distribution of an energy density of the laser beam, which cause differences in solidifying speed during cooling, resulting in the thin solidified layers. The thickness of the layers is about 0.2 mm, and depends upon the depth thereof. Columnar crystal grains are reduced in length by the formation of the remolten solidified layers, and hence the entire structure becomes fairly uniform.

An oxide coat film is formed on the surface of the surface-treated layer. The oxide coat film is formed by reaction with water and is a strong black coat. The oxide coat film has a thickness of several nm, which will contribute to the corrosion resistance property. The thickness of the film may be selected by the energy level of the laser beam. The material processed may be used with or without the oxide coat film. The film contains at least one metal in the aqueous solution, and hence exhibits a high corrosion resistance property.

The alloy in the surface-treated layer may contain at least one component at a content different from or larger than that of the component in the base material. In the case of the surface-treated layer being different in content of a component from the base material, the surface-treated layer will contain 0.1 to 1 wt.% of the component, and the component is uniformly distributed. The influence of the component, uniformly distributed in the surface-treated layer, on the base material is very large, and the content of the component may be increased to about 10 wt.%. The elements of groups IVa, Va, and VIa are capable of providing large effects even at a trace amount of 0.05 to 0.5%. Platinum group elements are capable of achieving great effects at a much lower content of 0.005 to 0.05%.

The process of the invention is directed to remelting a surface layer of a metallic member in a aqueous solution, and hence alloying of the element in a portion very close to the surface can be achieved, providing a high advantageous effect. The remelting of the surface of the metallic member in a solution by a laser beam is adjusted so that boiling of the solution may not occur in the surface of the metallic member. A surface state of the solution, the intensity and the traveling speed of the laser beam may be adjusted.

The invention is particularly directed to processing in an aqueous solution, and hydrogen contained in the surface-treated layer is distributed throughout the surface-treated layer due to rapid cooling.

Other than improvement of the corrosion resistance property as a method of improving a surface layer, the invention is capable of performing to improve the characteristics, such as wear resistance, of the base material by selecting metals to be contained in the surface layer of the base material.

### Example 1:

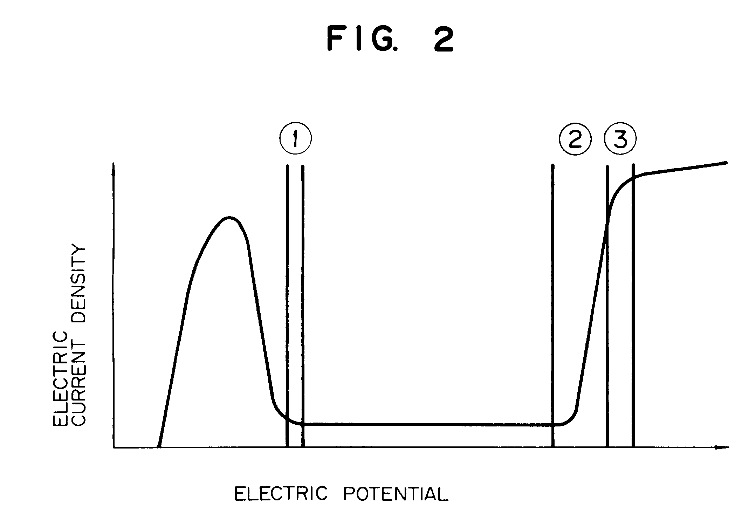

Table 1 shows a chemical composition of test pieces which were used in this example. After a solutionizing treatment (maintaining at 1050°C for 30 min., and water cooling thereafter), the test pieces were subjected to an ageing treatment at 750°C for 100 min.. The test pieces were polished (#240), and subsequently dipped in an aqueous solution which was produced by adding 0.5 M/ℓ of EDTA and 5 ppm of hydrazine, as reducing agents, to a 5% zirconium nitrate aqueous solution, and CO₂ laser beam was irradiated to the test pieces. The irradiation was conducted with 2 kW of laser beam output, focussing the beam at a position 10 mm away from above the test pieces. The laser beam traveled at speeds of 0.1, 0.2 and 0.5 m/min.. Evaluation of grain boundary corrosion resistance property was carried out by dipping tests at electric potential zones (1), (2) and (3) indicated in FIG. 2. Table 2 gives conditions of the corrosion tests at respective potential zones. The tests were conducted on the test pieces with an oxide coat film.

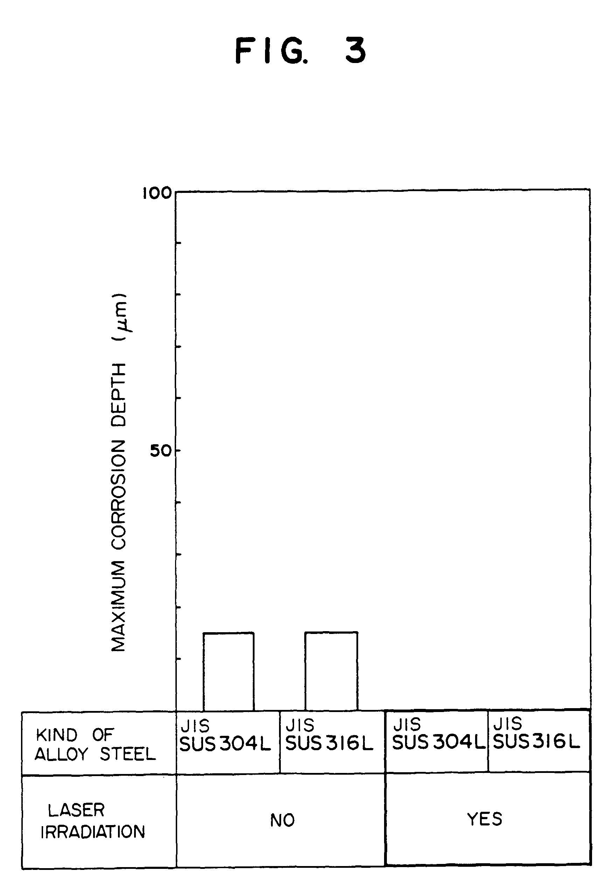

FIG. 3 illustrates effects of the laser irradiation on intergranular corrosion in an active state-passive state transition zone (Straus Testing). Although not laser processed portions of austenitic stainless steels of JIS SUS304L and SUS316L had a maximum corrosion depth of 15 µm which was rather large, in the laser processed portions of the invention no intergranular corrosion was confirmed, and the portions showed an excellent corrosion resistance property.

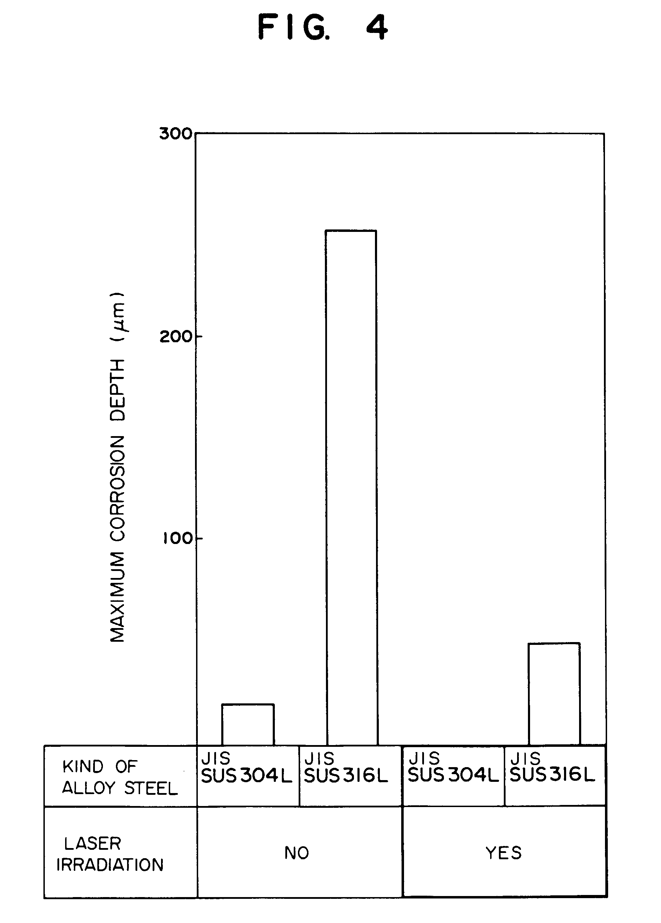

FIG. 4 is a graph which shows effects of the laser processing on intergranular corrosion in an active state-passive state transition zone (Huey Testing). Although the not laser processed portion of austenitic stainless steel of JIS SUS304L had a maximum corrosion depth of 20 µm which was rather large, in the laser processed portions of the invention no intergranular corrosion was confirmed.

Also, in the case of austenitic stainless steel of JIS SUS316L, the not laser processed portion had a maximum corrosion depth of 253 µm which was large as compared to JIS SUS316L, but the intergranular corrosion sensitivity was dropped about by 1/5, and showed an excellent corrosion resistance property.

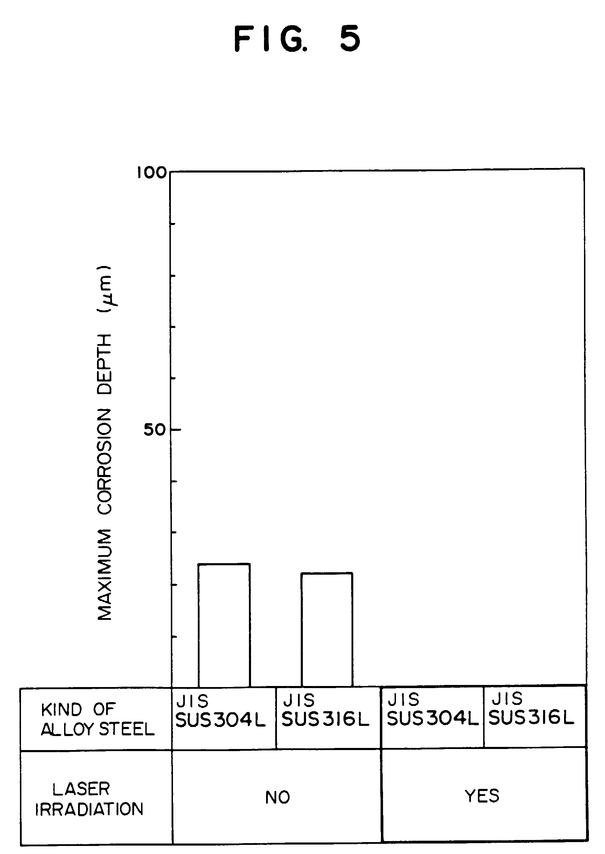

FIG. 5 is a graph showing effects of the laser processing on intergranular corrosion in an over-passive state zone (corrosion test in the solution of 9 N nitric acid and 10g/ℓ of Fe³⁺). Although not laser processed portions of austenitic stainless steel of JIS SUS304L and 316L had a maximum corrosion depth of twenty and several micron meter which was rather small, in the laser processed portions austenitic stainless steel of JIS SUS304L and 316L of the invention no intergranular corrosion was confirmed, and the portions showed an excellent corrosion resistance property.

In the foregoing tests, no influence of the traveling speed of 0.1 to 0.5 m/min. was noted, and in every speed the test pieces exhibited excellent corrosion resistance property.

As a result of observation of a section of each of austenitic stainless steel of JIS SUS304L test pieces laser irradiated, it was confirmed that: the remolten solidified layer portion had a thickness of about 1 mm and a cellular structure with a cellular grain size about 3 µm; delta ferrite with a grain size of about 0.5 µm was formed at each triangulation point of cellular grain boundaries of adjacent cellular grains; and a several nm thick black oxide coat film was firmly formed on the surface of the surface-treated layer. As a result of analysis, about 0.1 wt.% of Zr was alloyed in layer, and was also contained in the oxide coat film. In the the surface-treated layer, 4 to 6 interfaces between the minutely thin layers were formed substantially in parallel with a boundary between the non-remolten portion and the surface-treated layer. Zirconium was uniformly alloyed in the surface-treated layer.

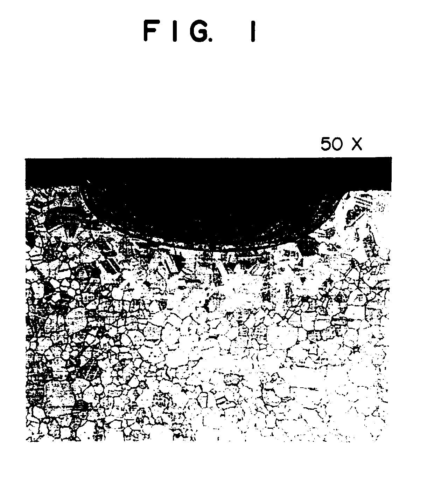

FIG. 1 is a microphotograph of two magnifications of a surface-treated layer of a test piece. As shown in FIG. 1, a plurality of the thin solidified layers were formed with a columnar cellular structure having a grain size of 3 µm.

### Example 2:

Test pieces of austenitic stainless steel of JIS SUS304L as described in Example 1 were prepared, and a laser beam was irradiated to the test pieces in the same manner as in Example 1 to thereby form about 0.5 mm thick surface-treated layer portion, using a 3% NiCl₂ aqueous solution, 5% Na₂MoO₄ aqueous solution, 2% orthosilicate soda aqueous solution, 1% NiCl₂ and 0.1% molybdic acid aqueous solution, 5% sodium titanate fluoride aqueous solution, and 4% CrCl₃ aqueous solution. EDTA and hydrazine were added to the aqueous solutions. In each test piece, it was confirmed that: in the surface-treated layer, a plurality of thin solidified layers, each of which about 0.2 mm thick, were formed as in Example 1; a cellular structure with a grain size 3 µm was formed; and an about 1 nm thick black oxide film was formed on the surface. About 2% of ferrite was contained. These test pieces underwent the same test, and as a result it was confirmed that each test piece had high corrosion resistance as compared to pieces conventionally processed. In the surface-treated layer and the oxide coat film of each test piece, a metal reduced from metallic ion was uniformly contained at a small amount of several percent or below.

### Example 3:

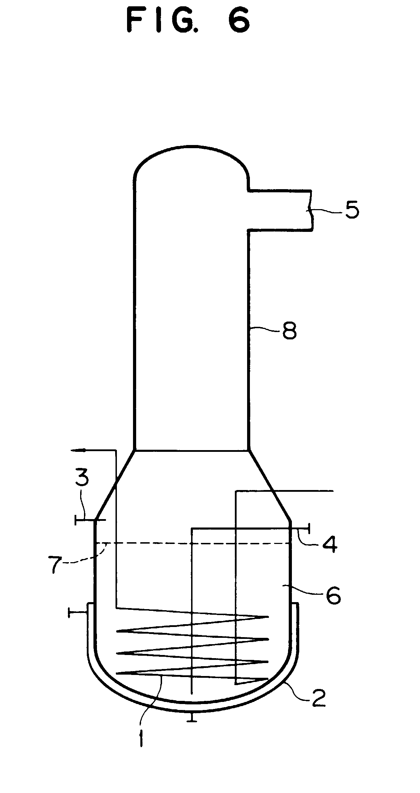

FIG. 6 illustrates a structure of a waste solution evaporator which was provided with a heater coil 1 which performs heating by flowing a heating medium through it, a jacket 2 for heating the outside thereof, a nitric acid solution inlet 3 and outlet 4, a nitric acid gas outlet 5 and a demister 8.

A nitric acid solution 6 was a 9N aqueous solution. The solution was heated by steam to about 80°C, and evaporated under reduced pressure. The level of the solution is indicated by the broken line 7, and in the vicinity of this line corrosion was the strongest. Austenitic stainless steels of JIS SUS304 and SUS304ULC were used in the body of the evaporator and the coil 1, respectively. The former contained 0.05 to 0.1% of carbon whereas the latter 0.005 to 0.02% of carbon. These components were previously brought into contact with the previously described aqueous solution containing Zr ion at 50 cm wide portions corresponding to the gas-solution interface to thereby form about 0.5 mm thick surface-treated layer. The evaporator thus obtained had an excellent corrosion resistance property as in the test pieces of the preceding examples.

It was found that the end surface of the nozzle of the inlet 3 was inferior in corrosion resistance, and an excellent corrosion resistance was obtained by similarly processing only the end surface. Thus, such processing of a surface perpendicular to the rolling direction is important.

The previously described reprocessing plant is provided with a fuel dissolving tank for dissolving a used nuclear fuel by a nitric acid solution. In the plant, uranium and plutonium are separated from the nitric acid solution which has dissolved the used nuclear fuel, and the waste solution is condensed in a waste solution evaporator. An acid recovering evaporator is used for removing further a waste solution from the nitric acid solution separated by the evaporator. The plant is further equipped with an acid recovering rectifying column to refine nitric acid from the nitric acid solution for reuse, and with a waste solution tank for storing a high or low level radioactive waste solution.

### Example 4:

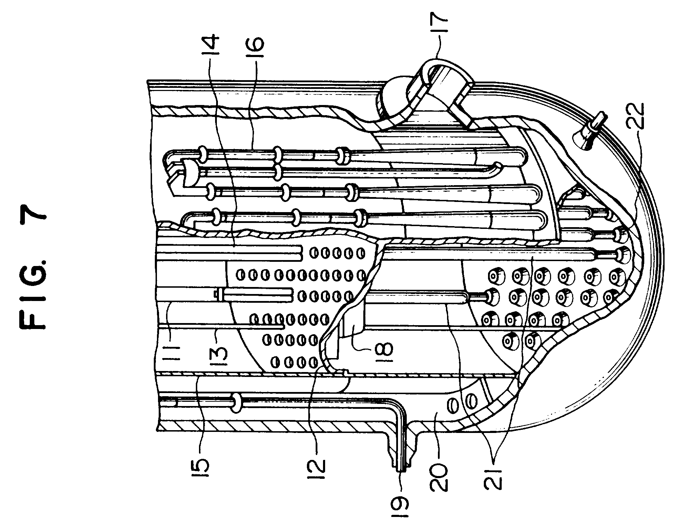

FIG. 7 is a fragmental diagrammatic perspective view of the reactor core portion of a boiling water reactor (BWR). In FIG. 7, reference numerals 11 to 15 designate a neutron source pipe, a reactor core supporting plate, a neutron counter, control rods, and a shroud or upper lattice plate, respectively. These structural components and equipment constituted boiling water reactor, and are large in the amount of neutron radiation. The structural components and equipment were used in high temperature and high pressure water (288°C, 7 MPa), and are made of an austenitic alloy.

The reactor core is provided with the following members: an upper mirror spray nozzle; a bent nozzle; a pressure vessel closure; a pressure vessel flange; a measurement nozzle; a steam separator; a shroud head; a feed water inlet nozzle; a jet pump 16; a recirculating water outlet nozzle 17; a steam dryer; a steam outlet nozzle; a feed water supercharger; a core spray nozzle; a lower core lattice 18; a recirculating water inlet nozzle 19; a baffle plate 20; a control rod guide tube 21; and a stub tube 22.

The pressure vessel is made of a carbon steel or a low alloy steel. The stub tube made of Inconel 600 of a nickel based alloy was welded to a portion butt welded in the inner surface of the vessel also by Inconel 600. Furthermore, a guide tube made of cast austenitic stainless steel (JIS SUS304) was welded to the stub tube. Since welding heat influenced portions of these components are likely to produce stress corrosion cracking, after welding, a laser beam was irradiated to the welding heat influenced portions with a width of an about 1 cm to thereby remelt it to a depth about 1 mm while the welded portions were in contact with an aqueous solution of ammonium molybdate. As a result, the surface-treated layer portion contained a small amount of Mo, and had an about 3 µm cellular structure. Four interfaces between the minutely thin solidified layers were formed substantially in parallel with the interface between the non-remolten portion and the surface-treated, and a black oxide coat film was formed on the back surface. The heat-affected zone was improved in the stress corrosion cracking property.

### Example 5:

A corrosion test was conducted at 160°C for 200 hours, using an aqueous solution as a lean solution containing 65 wt.% of lithium bromide, 0.2 wt.% lithium hydroxide, 0 to 3000 ppm, in term of NO₃⁻ concentration, of lithium nitrate and 5 mℓ/ℓ of n-octyl alcohol. The NO₃⁻ concentration dependency of the average amount of corrosion of the carbon steel had a local minimum at 350 ppm, and beyond this concentration the amount of corrosion rapidly increased. On the other hand, the amount of corrosion was rather large at an amount of zero ppm of NO₃⁻. Beyond 150 ppm of NO₃⁻, local corrosion including pitting corrosion took place. Although in the range between 5 to 150 ppm of NO₃⁻, the amount of corrosion was much larger than that at an amount of 350 ppm of NO₃⁻, there was an advantage that the corrosion was general corrosion which was very easily controlled in the freezer. From photographs of appearance of the carbon steel after the corrosion test, it was observed that general corrosion had been produced below 150 ppm of NO₃⁺ whereas beyond this concentration local corrosion including pitting corrosion had been produced.

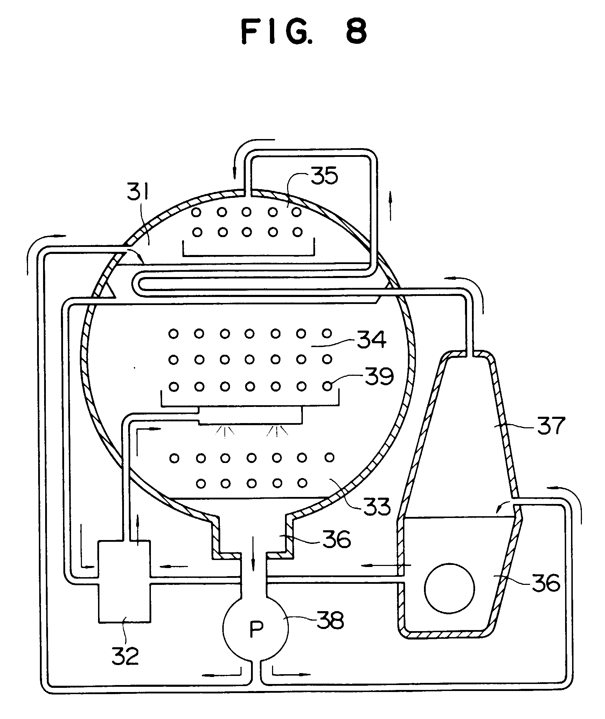

The sealed circulation absorption refrigerator has a restriction in that in operation the maximum pressure shold be below the atmospheric pressure, and generally, water is used as a coolant whereas a condensed aqueous solution of lithium bromide as the absorption solution. A principal system diagram of an absorption refrigerator to which the present invention is applied is shown in FIG. 8, in which the absorption refrigerator includes a low temperature regenerator 31, a heat exchanger 32, an absorber 33, an evaporator 34, a condenser 35, a high temperature regenerator 37 and a pump 38. The absorber 33, regenerator 31 and the pump 38 perform the same function as the compressor of the compressor refrigerator. During operation of the refrigerator, the lean solution is pumped as condensed lean solution 36 by the pump from the high temperature regenerator 37 to the absorber 33 through the heat exchanger 32, from which the lean solution is sent as thin lean solution to the regenerator 1 through the heat exchanger 32 for circulation.

Generally, the higher the concentration of the lean solution is (the temperature is high due to condensation), the higher the refrigerator becomes in refrigeration efficiency. For example, in the highest temperature regenerator 37, the temperature thereof becomes 160°C and the concentration of lithium bromide is 65% while in the lowest temperature absorber 33 the temperature is about 40°C with about 60% of lithium bromide. The higher both the temperature and the concentration of lithium bromide solution are, the stronger the corrosivity of the solution becomes. A carbon steel and a low alloy steel which are structural materials for the refrigerator are severely corroded if an appropriate amount of a corrosion inhibitor is added in the lean solution.

As previously described, corrosion is liable to be produced particularly in the high temperature regenerator 7 at the gas-solution interface, and hence in the aqueous solution containing Mo among the solutions in Example 2, a laser beam was irradiated to the regenerator 7 in the vicinity of the interface. As a result, an about 0.5 mm thick surface-treated layer was formed on the surface of the regenerator as well as an alloy layer containing about 1% of Mo. It was confirmed that a hard black oxide coat film of several nm thick had been formed on the surface of the alloy layer, and the regenerator had been excellent in corrosion resistance property as compared to unprocessed one. The oxide coat film included molybdenum (Mo).

Also, the low temperature regenerator 31 may be treated in the same manner as well as the heat transfer pipe.

### Example 6:

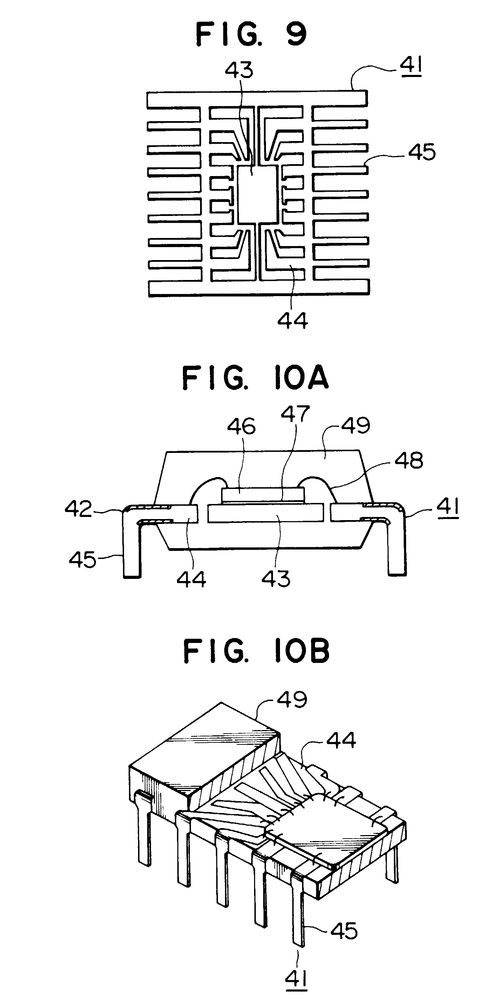

FIG. 9 is a plan view of a dual in-line package lead frame on which an alloy layer of Example 1 was formed.

A 0.3 mm thick 42 Alloy sheet (42% of Ni and the balance of Fe) was formed by etching into a predetermined shape of lead frame 41 of FIG. 9. The lead frame was dipped in an aqueous solution (40°C) having a composition including 0.5 g/ℓ of (NH₄)₆Mo₇O₂₄· 4H₂O, 200 g/ℓ of NiCl₂·6H₂O₇, 100 g/ℓ SnCl₂ and 200 g/ℓ NH₄Cl, and then a laser beam was irradiated to the lead frame to produce about 3 µm thick surface-treated layer containing Mo-Ni-Sn in the vicinity of the interface with the resin.

FIGs. 10A and 10B are vertical cross-sectional and perspective views of a semiconductor device using a lead frame in which the surface-treated layer 2 previously mentioned was formed. In the lead frame 41 made of 42 Alloy, the surface-treated layer 42 was formed in the vicinity of the interface, and a silicon chip 46 of which chip area on the circuit forming surface was 100 mm² was soldered on a chip mounting portion 43 of the lead frame,using a solder 47. Then, Al electrode pads and inner lead portion 44 on the silicon chip 46 were subjected to partial silver plating, and were then connected through gold wire 48, the former being ball bonded and the latter being wedge bonded. Then, the package was sealed with an epoxy resin 49. Silver was electroplated with masking so that silver plating was formed only in the bonding portions. Masking was also made in wedge bonded portions which was not subjected to silver plating. It was confirmed that clearance corrosion in the interface between the lead frame 41 and the epoxy resin 49 was prevented by the function of the remolten solidified layers 2 containing molybdenum, with the result that the semiconductor device was enhanced in reliability against moisture. A several tens angstrom thick oxide coat film including molybdenum was formed on the surface of the surface-treated layer 42.

Copper, tungsten, platinum group elements (Rn, Rh, Pd, Os, Ir and Pt), gold and silver may be used other than molybdenum. These elements are capable of being finely alloyed and uniformly dispersed without segregation in the matrix, and hence a particularly great effect can be achieved.

According to the present invention, a metallic member having an improved surface layer of a fine solidified structure can be obtained.

The invention is effectively applied to a gas-liquid interface portion or locally elevated temperature portion of a member, such as a heat-transfer tube and a tank, which contains highly oxidizable metallic ions in a nitric acid environment. The invention may be applied to a chemical plant, an industrial plant, nuclear plant equipments and structural elements thereof which are used under such an environment. Particularly, the invention achieves large advantageous effects by application to a heat-transfer tube of the nuclear fuel reprocessing plant, an acid recovering evaporator, a waste solution tank and a waste solution condensation evaporator.

The invention is capable of achieving large effects in application to the lead frame as an electronic component.

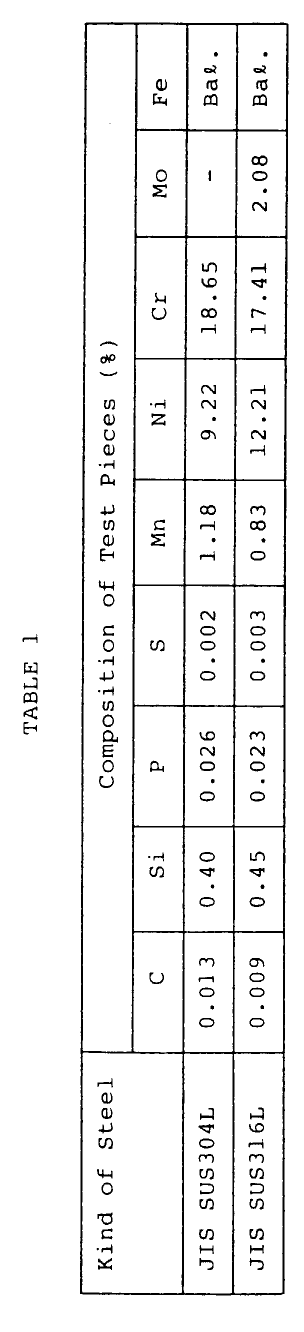

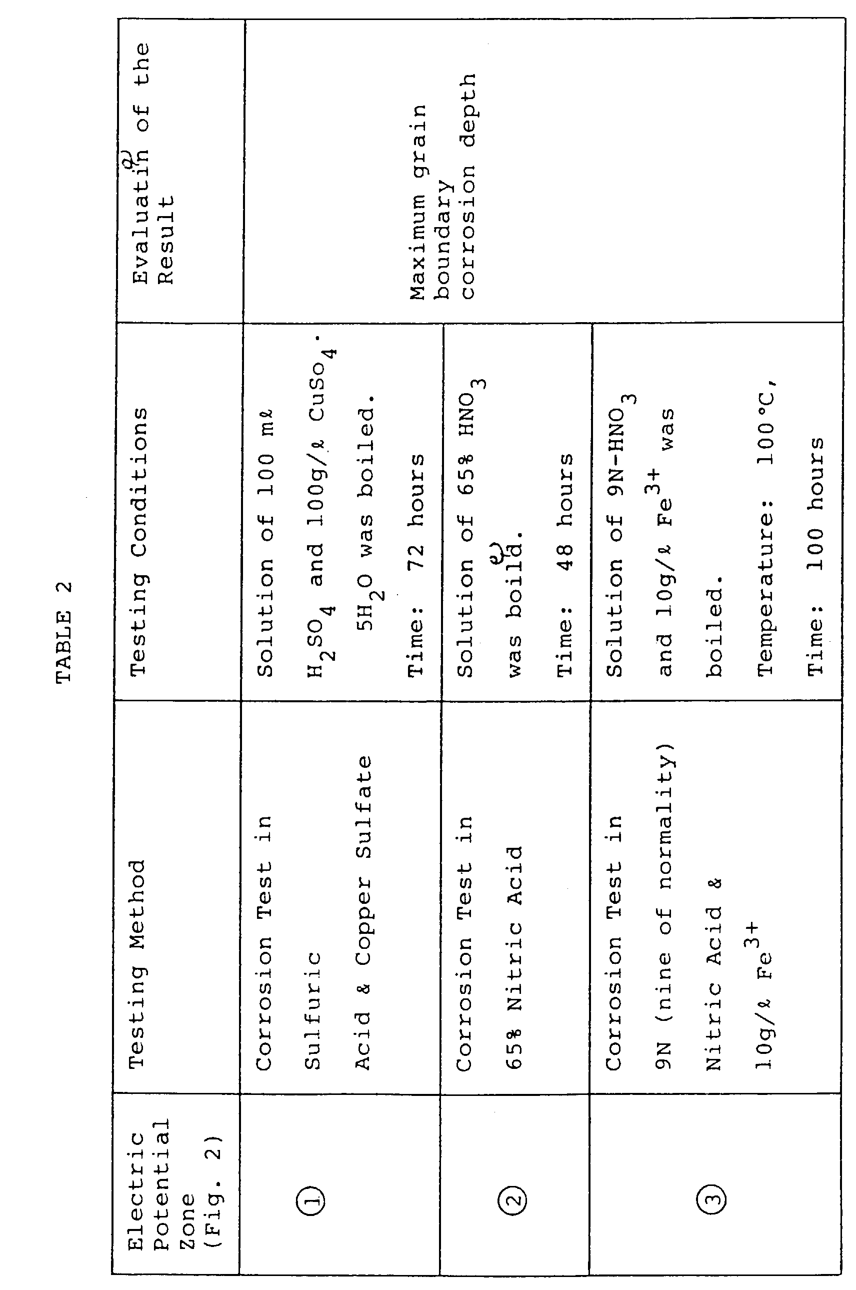

## Claims

1. A method of superficial modification of a metallic member comprising the steps of:
a) producing a modified surface layer comprising an oxide film coat formed on the surface layer of the metallic member by
a1) contacting the surface of the metallic member with an aqueous solution which contains at least one reducing agent selected from the group of EDTA, hydrazine, L-ascorbic acid, and indigo di-sulfonic acid, and at least one metallic ion selected from the group of IVa, Va, VIa, Cu, Au, Ag and the platinum group elements,
a2) irradiating through said aqueous solution with a laser beam to heat and remelt the surface layer of the metallic member, and
a3) solidifying the surface layer after remelting, whereby both the oxide film coat and the surface layer contain the metal reduced from said metallic ion.

2. A method of superficial modification of a metallic member according to claim 1, wherein the surface layer is rapidly remolten and subsequently rapidly cooled to solidify primarily by the self mass of the metallic member.

3. A method of superficial modification of a metallic member according to claim 1, wherein the metallic member is made of a material selected from the group of austenitic stainless steel, carbon steel, a low alloy steel, aluminum, an aluminum alloy, copper, a copper alloy, an Fe-Ni alloy with a low thermal expansion coefficient, a heat resistant steel, a nickel base alloy and a cobalt base alloy.

4. A metallic member consisting of a base material and a modified surface layer, wherein said surface layer consists of a plurality of minutely thin layers, and is obtained by a method comprising the steps of
a) producing a modified surface layer comprising an oxide film coat formed on the surface layer of the metallic member by
a1) contacting the surface of the metallic member with an aqueous solution which contains at least one reducing agent selected from the group of EDTA, hydrazine, L-ascorbic acid, an indigo di-sulfonic acid, and at least one metallic ion, selected from the group of IVa, Va, VIa, Cu, Au, Ag and the platinum group elements,
a2) irradiating through said aqueous solution with a laser beam to heat and remelt the surface layer of the substrate, and
a3) solidifying the surface layer after remelting, whereby both the oxide film coat and the surface layer contain the metal reduced from said metallic ion.

5. A metallic member according to claim 4, wherein said modified surface layer is covered by a black oxide coat film.

6. A metallic member according to claim 4 or 5, wherein said modified surface layer contains at least one alloying element whereof the content is larger by 0.1 to 1 wt.% than that of the body of the metallic member.

7. A metallic member according to claim 4 or 5, wherein said modified surface layer contains hydrogen, whereof the content is larger than that of the body of the metallic member.

8. A metallic member according to anyone of claims 4 to 7, wherein said modified surface layer has a cellular structure of a cellular grain size of 10 µm at maximum.

9. A metallic member with a modified surface layer having a cellular structure of a cellular grain size of 10 µm at maximum, the modified surface layer being obtained by a method according to anyone of claims 1 to 3.

## Patentansprüche

1. Verfahren zur Oberflächenverbesserung eines Metallbauteils, das die Schritte aufweist:
a) Erzeugen einer veränderten Oberflächenschicht mit einem Oxidfilmüberzug, der auf der Oberflächenschicht des Metallbauteils gebildet wird durch
a1) Kontaktieren der Oberfläche des Metallbauteils mit einer wässerigen Lösung, die wenigstens ein aus der Gruppe von EDTA, Hydrazin, L-Ascorbinsäure und Indigodisulfonsäure gewähltes Reduktionsmittel und wenigstens ein aus der Gruppe von IVa, Va, VIa, Cu, Au, Ag und den Platingruppenelementen gewähltes Metallion enthält,
a2) Bestrahlen durch die wässerige Lösung mit einem Laserstrahl zum Erhitzen und Umschmelzen der Oberflächenschicht des Metallbauteils und
a3) Erstarren der Oberflächenschicht nach dem Umschmelzen,
wodurch sowohl der Oxidfilmüberzug als auch die Oberflächenschicht das vom Metallion reduzierte Metall enthalten.

2. Verfahren zur Oberflächenverbesserung eines Metallbauteils nach Anspruch 1,
bei dem die Oberflächenschicht rasch umgeschmolzen und anschließend rasch abgekühlt wird, um hauptsächlich durch die Eigenmasse des Metallbauteils zu erstarren.

3. Verfahren zur Oberflächenverbesserung eines Metallbauteils nach Anspruch 1,
bei dem das Metallbauteil aus einem aus der Gruppe von austenitischem nichtrostendem Stahl, Kohlenstoffstahl, niedrig legiertem Stahl, Aluminium, einer Aluminiumlegierung, Kupfer, einer Kupferlegierung, einer Fe-Ni-Legierung mit einem niedrigen Wärmeausdehnungskoeffizient, einem hitzebeständigen Stahl, einer Nickelbasislegierung und einer Kobaltbasislegierung gewählten Material besteht.

4. Metallbauteil, das aus einem Basismaterial und einer verbesserten Oberflächenschicht besteht, wobei die Oberflächenschicht aus winzig dünnen Schichten besteht und durch ein Verfahren erhalten wird, das die Schritte aufweist:
a) Erzeugen einer veränderten Oberflächenschicht mit einem Oxidfilmüberzug, der auf der Oberflächenschicht des Metallbauteils gebildet wird durch
a1) Kontaktieren der Oberfläche des Metallbauteils mit einer wässerigen Lösung, die wenigstens ein aus der Gruppe von EDTA, Hydrazin, L-Ascorbinsäure und Indigodisulfonsäure gewähltes Reduktionsmittel und wenigstens ein aus der Gruppe von IVa, Va, VIa, Cu, Au, Ag und den Platingruppenelementen gewähltes Metallion enthält,
a2) Bestrahlen durch die wässerige Lösung mit einem Laserstrahl zum Erhitzen und Umschmelzen der Oberflächenschicht des Metallbauteils und
a3) Erstarren der Oberflächenschicht nach dem Umschmelzen,
wodurch sowohl der Oxidfilmüberzug als auch die Oberflächenschicht das vom Metallion reduzierte Metall enthalten.

5. Metallbauteil nach Anspruch 4,
wobei die verbesserte Oberflächenschicht mit einem schwarzen Oxidüberzugsfilm bedeckt wird.

6. Metallbauteil nach Anspruch 4 oder 5,
wobei die verbesserte Oberflächenschicht wenigstens ein Legierungselement enthält, dessen Gehalt um 0,1 bis 1 Gew.% höher als der des Körpers des Metallbauteils ist.

7. Metallbauteil nach Anspruch 4 oder 5,
wobei die verbesserte Oberflächenschicht Wasserstoff enthält, dessen Gehalt höher als der des Körpers des Metallbauteils ist.

8. Metallbauteil nach einem der Ansprüche 4 bis 7,
wobei die verbesserte Oberflächenschicht eine zellenartige Struktur einer Zellenkorngröße von maximal 10 µm hat.

9. Metallbauteil mit einer verbesserten Oberflächenschicht, die eine zellenartige Struktur einer Zellenkorngröße von maximal 10 µm hat, welche verbesserte Oberflächenschicht durch ein Verfahren nach irgendeinem der Ansprüche 1 bis 3 erhalten ist.

## Revendications

1. Procédé de modification superficielle d'un élément métallique, comprenant les étapes consistant à :
a) produire une couche de surface modifiée comprenant un revêtement en film d'oxyde formé sur la couche de surface de l'élément métallique par :
a1) mise en contact de la surface de l'élément métallique avec une solution aqueuse qui contient au moins un agent réducteur choisi dans le groupe comprenant l'EDTA, l'hydrazine, l'acide L-ascorbique, et l'acide indigo-disulfonique, et au moins un ion métallique choisi dans le groupe comprenant les éléments des Groupes IVa, Va, VIa, le cuivre, l'or, l'argent et les éléments du groupe du platine,
a2) rayonnement à travers ladite solution aqueuse d'un faisceau de laser pour chauffer et refondre la couche de surface de l'élément métallique, et
a3) solidification de la couche de surface après la refusion, grâce à quoi le revêtement en film d'oxyde et la couche de surface contiennent tous deux le métal réduit à partir dudit ion métallique.

2. Procédé de modification superficielle d'un élément métallique selon la revendication 1, dans lequel la couche de surface est rapidement refondue, et ensuite rapidement refroidie pour se solidifier principalement sous l'effet de la propre masse de l'élément métallique.

3. Procédé de modification superficielle d'un élément métallique selon la revendication 1, dans lequel l'élément métallique est réalisé en un matériau choisi dans le groupe comprenant l'acier inoxydable austénitique, l'acier au carbone, un acier allié à faible teneur, l'aluminium, un alliage d'aluminium, le cuivre, un alliage de cuivre, un alliage Fe-Ni avec un faible coefficient de dilatation thermique, un acier résistant à la chaleur, un alliage à base de nickel et un alliage à base de cobalt.

4. Elément métallique composé d'un matériau de base et d'une couche de surface modifiée, dans lequel ladite couche de surface se compose d'une pluralité de couches extrêmement minces, et est obtenue à l'aide d'un procédé comprenant les étapes consistant à :
a) produire une couche de surface modifiée comprenant un revêtement en film d'oxyde formé sur la couche de surface de l'élément métallique par :
a1) mise en contact de la surface de l'élément métallique avec une solution aqueuse qui contient au moins un agent réducteur choisi dans le groupe comprenant l'EDTA, l'hydrazine, l'acide L-ascorbique, et l'acide indigo-disulfonique, et au moins un ion métallique choisi dans le groupe comprenant les éléments des Groupes IVa, Va, VIa, le cuivre, l'or, l'argent et les éléments du groupe du platine,
a2) rayonnement à travers ladite solution aqueuse d'un faisceau de laser pour chauffer et refondre la couche de surface du substrat, et
a3) solidification de la couche de surface après refusion, grâce à quoi le revêtement en film d'oxyde et la couche de surface contiennent tous deux le métal réduit à partir dudit ion métallique.

5. Elément métallique selon la revendication 4, dans lequel ladite couche de surface modifiée est recouverte d'un film de revêtement d'oxyde noir.

6. Elément métallique selon la revendication 4 ou 5, dans lequel ladite couche de surface modifiée contient au moins un élément d'alliage dont la teneur est supérieure de 0,1 à 1% en poids à celle du corps de l'élément métallique.

7. Elément métallique selon la revendication 4 ou 5, dans lequel ladite couche de surface modifiée contient de l'hydrogène, dont la teneur est supérieure à celle du corps de l'élément métallique.

8. Elément métallique selon l'une quelconque des revendications 4 à 7, dans lequel ladite couche de surface modifiée a une structure cellulaire ayant une taille de grain cellulaire de 10µm au maximum.

9. Elément métallique avec une couche de surface modifiée ayant une structure cellulaire avec une taille de grain cellulaire de 10µm au maximum, la couche de surface modifiée étant obtenue par un procédé selon l'une quelconque des revendications 1 à 3.
